(19) Europäisches Patentamt / European Patent Office / Office européen des brevets

(11) **EP 2 786 165 B1**

(12) **EUROPEAN PATENT SPECIFICATION**

(45) Date of publication and mention of the grant of the patent:
**16.09.2015 Bulletin 2015/38**

(21) Application number: **11793393.7**

(22) Date of filing: **30.11.2011**

(51) Int Cl.:
*G01R 33/44* [(2006.01)]    *G01N 24/08* [(2006.01)]
*G01R 33/46* [(2006.01)]

(86) International application number:
**PCT/EP2011/071392**

(87) International publication number:
**WO 2013/079106 (06.06.2013 Gazette 2013/23)**

(54) **METHOD FOR THE NMR BASED DETERMINATION OF THE AFFINITY OF DRUGS FOR A TARGET PROTEIN**

VERFAHREN FÜR NMR-BASIERTE BESTIMMUNG DER AFFINITÄT VON ARZNEIMITTELN FÜR EIN ZIELPROTEIN

PROCÉDÉ POUR DÉTERMINATION BASÉE SUR RÉSONANCE MAGNÉTIQUE NUCLÉAIRE (RMN) DE L'AFFINITÉ DE MÉDICAMENTS POUR UNE PROTÉINE CIBLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.10.2014 Bulletin 2014/41**

(73) Proprietor: **Ecole Polytechnique Fédérale de Lausanne (EPFL)**
**1015 Lausanne (CH)**

(72) Inventors:
• **BODENHAUSEN, Geoffrey**
  **F-75014 Paris (FR)**
• **BORNET, Aurélien**
  **CH-1997 Haute-Nendaz (CH)**
• **SALVI, Nicola**
  **CH-1007 Lausanne (CH)**
• **BURATTO, Roberto**
  **I-37030 Montecchia di Crosara (IT)**

(74) Representative: **Bremi, Tobias Hans**
**Isler & Pedrazzini AG**
**Postfach 1772**
**8027 Zürich (CH)**

(56) References cited:
**WO-A1-03/104778**

• **VALENSIN G ET AL: "SELECTIVE PROTON NMR RELAXATION INVESTIGATIONS OF MEMBRANE-BOUND DRUGS IN-VITRO 1. COLCHICINE", BIOPHYSICAL CHEMISTRY, vol. 22, no. 1-2, 1985, pages 83-88, XP002679841, ISSN: 0301-4622**
• **CARRAVETTA M ET AL: "Long-lived nuclear spin states in high-field solution NMR", JOURNAL OF THE AMERICAN CHEMICAL SOCIETY, vol. 126, no. 20, 26 May 2004 (2004-05-26) , pages 6228-6229, XP002298311, AMERICAN CHEMICAL SOCIETY, WASHINGTON, DC; US ISSN: 0002-7863, DOI: 10.1021/JA0490931 cited in the application**
• **LEPRE CHRISTOPHER A ET AL: "Theory and applications of NMR-based screening in pharmaceutical research.", CHEMICAL REVIEWS, vol. 104, no. 8, August 2004 (2004-08), pages 3641-3675, XP002679882, ISSN: 0009-2665**
• **SALVI N. ET AL.: "Boosting the Sensitivity of Ligand-Protein Screening by NMR of Long-Lived States", JOURNAL OF THE AMERICAN CHEMICAL SOCIETY, vol. 134, 22 June 2012 (2012-06-22), pages 11076-11079, XP002679883,**

**Description**

TECHNICAL FIELD

The present invention relates to a method for the NMR based determination of the affinity of drugs for a target protein and to the use of singlet state relaxation for the determination of binding constants in solution.

PRIOR ART

The biological functions of biomolecules are usually performed by interactions with other biomolecules or smaller ligands, e.g. hormones, substrates, etc. Therefore, a fundamental goal in pharmaceutical research and drug development is to find natural or synthetic molecules that interact specifically and strongly with a target biomolecule, promoting or inhibiting its activity. This quest is often carried out using biological assays such as Enzyme-Linked ImmunoSorbent Assay (ELISA) or physicochemical methods, e.g. isothermal titration calorimetry or surface plasmon resonance.

Recently, NMR techniques emerged as a powerful approach for the identification of lead compounds in drug discovery and for the investigation of protein-ligand interactions, with a variety of advantages. In fact, NMR methods extend the range of measurable interactions, i.e. it is possible to measure KD defined as

$$K_D = \frac{[P] \cdot [L]}{[PL]} = \frac{k_{off}}{k_{on}}$$

(1)

with $k_{on}$ and $k_{off}$ the kinetic association and dissociation constant, and [P], [L] and [PL] the concentration of free protein, free ligand and proteinligand complex, respectively in the mM range, to whom the traditional methods are less sensitive or even completely blind. NMR provides also atomic resolution and versatility, due to the multiplicity of possible probes both on the protein and on the ligand, such as chemical shifts, relaxation rates and magnetization transfer rates.

The scientific article entitled "Selective 1H-NMR relaxation investigations of membrane-bound drugs in vitro" by Valensin et. al (Biophysical Chemistry 22 (1985) 83-87) discloses the measurement of binding of colchicine to vesicles by measuring the proton selective spin lattice relaxation rates $R^s$. It is shown that the apparent equilibrium constant between the free state and the bound state is a function of the selective proton spin-lattice relaxation rate allowing for a determination of the apparent equilibrium constant by measurement of the selective proton spin-lattice relaxation rate and by extrapolating the plot of $1/\Delta R^s$ versus the concentration of the free colchicine to zero.

SUMMARY OF THE INVENTION

A powerful new method for the study of drug-protein interactions by NMR is proposed. This technique exploits the peculiar relaxation properties of long-lived nuclear singlet states, i.e. the conservation of the nuclear spin order for a time longer than the longitudinal relaxation time. Experimental and theoretical evidence shows that the new method provides contrast and sensitivity greater than previous methods. The method was applied to the screening of potential inhibitors of the urokinase-type plasminogen activator (uPA).

In the last few years Long Lived States (LLS), which have the property of storing the magnetization for a time longer than the longitudinal relaxation time constant ($T_1$), were discovered (see e.g. Carravetta M & Levitt MH (2004) Long-lived nuclear spin states in high-field solution NMR. J Am Chem Soc 126(20):6228-6229), and subsequently applied to a wide range of systems.

Here we propose the use of LLS's excited on a weak ligand as a probe for ligand-binding interactions. On the basis of the results of simulations, we argument that the proposed method benefits from an enhanced contrast (i.e., a bigger difference between the values of the quantity of interest of the free and the bound ligand), when compared to analogous methods that exploit other NMR probes (e.g., $T_1$). Because of the improved contrast, this technique allows to study even stronger (KD < 1 mM) interactions, without requiring any isotopic labeling and demanding a much smaller amount of protein. The theoretical evidences are supported by experimental results. We applied our method to the screening of potential inhibitors of a target for cancer therapy, the urokinase-type plasminogen activator (uPA), a 52-kDa serine protease involved in the signaling pathways responsible for tumor growth, metastasis and inflammation.

More generally, the present invention relates to a method for the determination of the binding properties of at least one first chemical compound to at least one second chemical compound between a free essentially dissociated state and a bound essentially associated state by using nuclear magnetic resonance (NMR) measurements. At least one of the first chemical compound or the second chemical compound comprises two coupled 1/2 spins in inequivalent molecular sites. This makes sure that it is possible, for example by using corresponding irradiation techniques, to provoke differential relaxation behavior between the bound and free state allowing for the corresponding sensitivity on the dissociation/association between the two states.

Particularly high sensitivity and pronounced differential behavior between bound and unbound state is possible if the two coupled 1/2 spins in inequivalent molecular sites are such that the difference in Larmor frequency is larger than the J-coupling between the two spins.

Especially high sensitivity and pronounced differential behavior between bound and unbound state is possible, if the chemical shift of at least one of said spins in the free state is different from the chemical shift in the bound state.

In accordance with the proposed method, the relaxation of a long-lived state of the spin pair is measured as a function of the concentration of at least one of said first chemical compound or second chemical compound for the determination of the equilibrium constant ($K_D$) between the free state and the bound state.

According to a first preferred embodiment of the proposed method, the chemical shift difference between the free state and the bound state of at least one of said spins can be at least 0.2 ppm, preferably at least 0.3 ppm, more preferably in the range of 0.3 - 4 ppm. The larger the chemical shift difference the more efficiently it is possible to provoke differential relaxation behavior between the bound and the free state by corresponding tailoring of the relaxation of the long-lived state of the spin pair.

According to yet another preferred embodiment of the proposed method, the chemical shift value of both coupled 1/2 spins in the free state is different from the respective chemical shift value in the bound state.

The measurement of the relaxation of a long-lived state of the spin pairs preferably includes the steps of

(i) generation of zero quantum coherence and longitudinal two spin order in the ensemble of spin pairs,
(ii) evolution of the zero quantum coherence and longitudinal two spin order under suppression of the chemical shift difference, and
(iii) conversion of the zero quantum coherence and longitudinal two spin order into a measurable coherence, and

wherein the relaxation behaviour is determined as the time constant (RobsA) of the decay in step (ii).

The suppression of the chemical shift difference can take place via radiofrequency irradiation, for example by using a multi-pulse sequence or using unmodulated radiofrequency continuous wave irradiation. Most preferably this irradiation is applied at a frequency which is centered between the two chemical shift values of the two spins in either the bound state or the free dissociated state.

The dissociation constant $K_D$ of the equilibrium between the free state and the bound state according to the above Eq. (1) can be determined based on the time constant of the relaxation of the long-lived state of the spin pairs and on the relationship of Eq. (4) given further below.

The two coupled 1/2 spins can be two protons, for example attached to the same heteroatom, preferably the two $H_\alpha$ protons of a glycine residue.

The first chemical compound is for example a biopolymer, preferably a protein, carbohydrate or nucleic acid-based system, or a combination thereof, and the second chemical compound is a smaller, preferably monomeric or oligomeric molecular entity, preferably a potential drug compound. The two coupled 1/2 spins are preferably spins of the smaller molecular entity, for example attached to the same heteroatom.

The long-lived state of the spin pair is determined under evolution conditions where interconversion to the triplet state is prevented essentially only if the corresponding chemical compound is in the free state or is in the bound state but not in the respective other state.

The measurement for example involves pulsed nuclear magnetic resonance and Fourier transform techniques, and wherein the actual measurement is carried out in a one-dimensional, or multidimensional, preferably a two-dimensional or three-dimensional manner, preferably involving transfer of magnetization between different nuclear species. The invention further relates to the use of the measurement of long-lived states in NMR for the determination of the affinity of drugs for a target biomolecule, for example protein, preferably using a method as outlined above.

Further embodiments of the invention are laid down in the dependent claims.

Long Lived States (LLS) can thus be used as a new probe to study protein-ligand interactions. The use of LLS's permits to increase the contrast in ligand binding studies. A two-fold advantage can be obtained: on the one hand, the protein concentration can be reduced up to a factor 20, with respect to $T_1$-based methods; on the other hand, the ligand/protein ratio can be increased, resulting in a gain in terms of time, or material with respect to conventional longitudinal relaxation methods.

LLS can be sustained in peptides containing correspondingly suitable spin systems such as glycines. Such a residue can be a versatile scaffold that greatly facilitates the search of a suitable weak ligand. Moreover, the synthesis of peptidic binders can be usually achieved without great efforts and is rather inexpensive.

Furthermore, the LLS method allows the characterization of interactions of very different strength. Indeed, dissociations constants in a window that spans nearly five orders of magnitude were determined.

Finally, it is worth pointing out that LLS's can be used in conjunction with methods of screening of a compound library for drug discovery. For instance, a single LLS spectrum of a weak "spy" ligand can be acquired with a fixed sustaining delay in the presence of a compound to be screened: if the latter is a stronger ligand, the LLS signal of the weak "spy" binder will gain in intensity, while the singlet state will decay fast in the opposite case.

BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

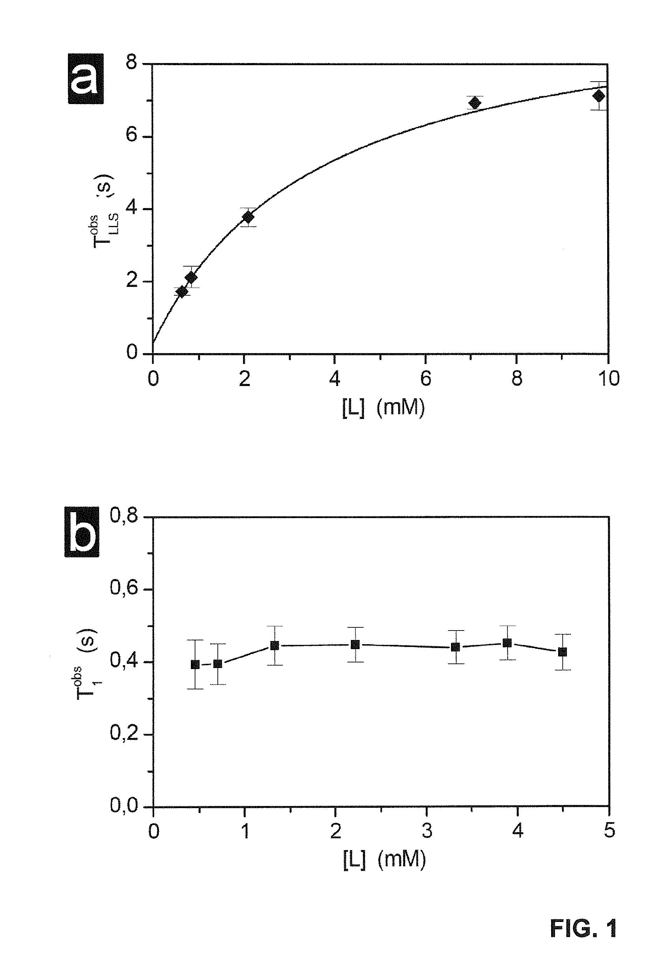

Fig. 1 (a) shows the lifetimes $T_{LLS}$ of the long-lived states associated with the two $H_\alpha$' protons of the central glycine residue in the tripeptide ligand L = Glycine-Glycine-Arginine (GGR) in the presence of 10 $\mu$M of the protein uPA, as a function of the concentration [L] at 8°C in D2O; the curve shows a fit of the experimental data to Eq. 3; (b) shows conventional spinlattice relaxation times $T_1$ of the $H_\alpha$ protons of the central glycine residue in the ligand L = GGR, measured as a function of the concentration [L] under the same conditions than in (a);

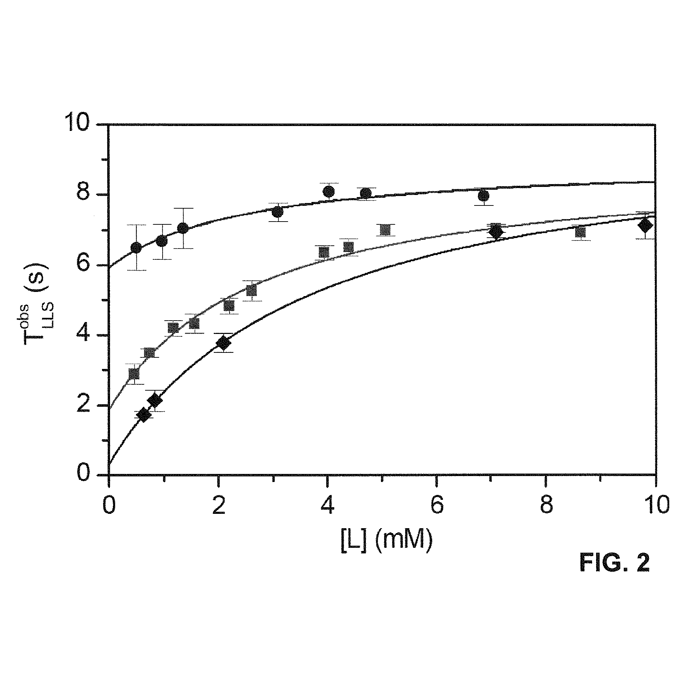

Fig. 2 shows the lifetimes TLLS of the long-lived states associated with the two $H_\alpha$' protons of the central glycine residue in the tripeptide ligand L = GGR in the presence of 10 $\mu$M of the protein uPA, as a function of the concentration [L] at 8°C in $D_2O$: ($\blacklozenge$) in the absence of any competing ligands, ($\blacksquare$) in the presence of 12 $\mu$M of 4-aminobenzamidin, and ($\bullet$) in the presence of 12 $\mu$m of UK-18, all recorded under the same conditions as in Fig 1; experimental data were fitted to Eq. 3 if there is no competitor and to Eq.4 to describe the effects of competitors; and

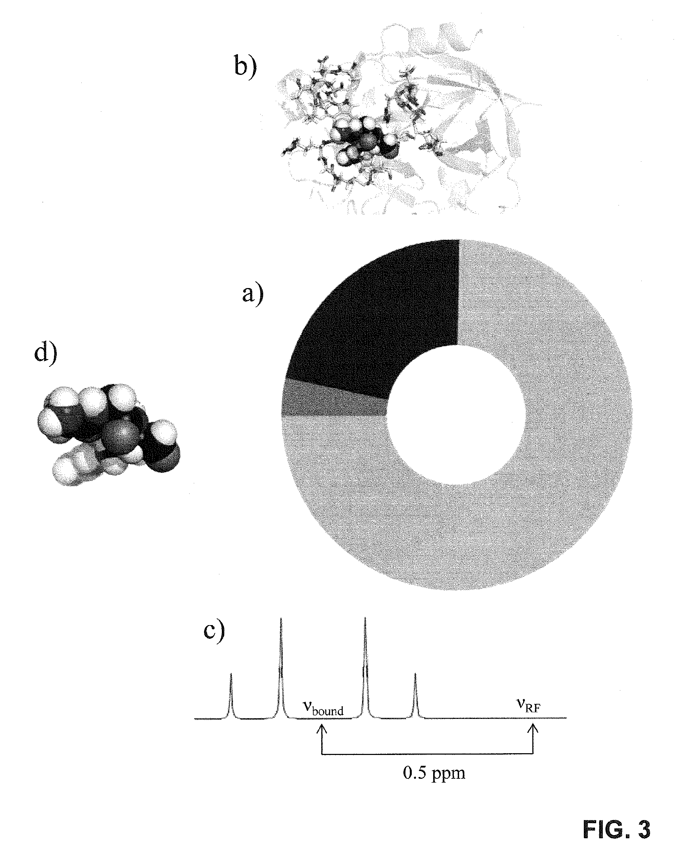

Fig. 3 diagrammatically in (a) shows the relative contributions to the relaxation rates $R_{LLS} = 1/T_{LLS}$ of the long-lived singlet state of the two $H_\alpha$ protons in the central glycine in the tripeptide ligand GGR when it forms a complex with the protein uPA (b), wherein it is assumed that complexation leads to displacement of the average chemical shift (c) of 0.5 ppm (200 Hz at 400 MHz), and that the rf field used to sustain the LLS is monochromatic and has an amplitude $\nu_1 = \omega_1/(2\pi) = 1000$ Hz adapted to a difference in chemical shifts of the unbound ligand L (see d) of 100 Hz.

DESCRIPTION OF PREFERRED EMBODIMENTS

As mentioned, the methodology proposed in this application benefits from increased sensitivity and contrast with respect to other NMR-based methods, and in particular with respect to the methods based on the measure of longitudinal relaxation times. First we discuss the mechanisms that are responsible for this increase in contrast and subsequently experimental evidence is presented.

In the case of a ligand that is in dynamic equilibrium between free and bound forms (see Eq.1), with exchange rates that are fast on the NMR timescale, any observed NMR relaxation rate

$$(R_A^{obs} = 1/T_A^{obs})$$

is the weighted average between the rates of the free and bound forms:

$$R_A^{obs} = X^b \cdot R_A^b + X^f \cdot R_A^f \tag{2}$$

where A = LLS, 1 or 2, $R_A^b$ and $R_A^f$ are the rates for the bound and free ligand, and $X^b$ and $X^f$ the mole fractions of the bound and free ligand, respectively. With the definition of $X^b$ and $X^f$ and of the dissociation constant $K_D$, Eq. 3 can be derived:

$$R_A^{obs} = \frac{[P]_0}{[L]_0 + K_D} \cdot \left( R_A^b - R_A^f \right) + R_A^f$$

(3)

where $[P]_0$ and $[L]_0$ are the total protein and ligand concentration, respectively. Eq. 3 shows that the contrast (i.e. the change of $R_A^{obs}$ induced by changing $[L]_0$) and therefore the sensitivity of the method (i.e. the smallest $X^b$ that it is possible to detect) are increased if the difference $R_A^b$ - $R_A^f$ is increased.

Indeed, both experimental results and numerical simulations of the spin dynamics of our system show that the maximum value of the abovenamed difference is found for relaxation times $T_{LLS}$. In particular, we simulated the dipole-dipole contributions (the main relaxation pathway in liquid state NMR) to the longitudinal and LLS relaxation for the free and bound GGR. The dipole-dipole interactions with the protons in the binding site of the protein uPA contribute roughly to the 85% of the observed relaxation rate, both in the case of conventional longitudinal relaxation times $T_1$ and $T_{LLS}$. A completely different situation emerges if one considers the fact that the chemical shifts of the two glycine $H_\alpha$'s may change upon binding. An accurate experimental measure of the binding-induced chemical shift difference is not available. However, it is possible to obtain a rough estimate of the chemical shifts of the two glycine protons in the free and bound forms (see below). It is therefore possible to estimate that the frequency shift induced by binding is about 0.5 ppm (i.e., 200 Hz for the protons in our experiments at 400 MHz, more in proportion to the static field strength). Conventional longitudinal relaxation is not influenced by this shift, but it has a dramatic effect on the lifetimes of the LLS. Indeed, during the relaxation period, as described further below, a radio-frequency (rf) field is used to mask the chemical shift difference between the two protons involved in the LLS. The suppression is efficient if the carrier frequency corresponds to the center between the two doublets of the two glycines $H_\alpha$ protons. Experimentally, the carrier must be set to the proper value for the free ligand. When the ligand is bound, there is an important mismatch due to the chemical shift change upon binding and the singlet state decays rapidly, so that its lifetime is reduced. Indeed, schematic Figure 3 shows that about the 75 % of the LLS relaxation rate of the bound ligand may be due to the effect of the mismatch occurring upon binding. These coherent effects introduced by the rf field may provide the rationale behind the enhanced contrast of the LLS-based method.

Besides, additional effects may expand the contrast even more. In particular, the rotational correlation time ($\tau_c$) of the protein is much longer than the one of the tripeptide. Therefore, it is likely that the bound ligand experiences a slower rotational motion and a faster relaxation. However, because of the shaking of the ligand in the binding pocket, the $\tau_c$ of the bound tripeptide does not in general coincide with the $\tau_c$ of the protein. Consequently, a quantitative assessment of this effect is not possible, although its contribution to the contrast should be positive but less important than the one produced by the coherent effects.

In addition to conventional longitudinal relaxation rates, also transverse relaxation rates ($T_2$) and translational diffusion coefficients (D) have been used to probe ligand-protein interactions. In general, relaxation rate experiments are more direct and faster than the diffusion-based methods, and, if special approaches are adopted to reduce the experimental time, the precision of the method is greatly reduced. The assessment of proton $T_2$s is usually made difficult by the homonuclear J-coupling-induced modulations. Therefore, T2-based methods have to rely on the presence of an isolated heteronuclear spin (e.g. $^{19}$F) or on the fitting of linewidth data. The method that we propose here do not suffer from the loss of versatility and signal intensity due to the use of heteronuclei nor from the influence of instrumental variables, e.g., the inhomogeneity of the magnetic field, that affects the spectral linewidths.

Experimental section:

It was shown by phage display using a peptide library and consensus sequence analysis that peptide binders of the protein uPA must contain at least one arginine residue. The two H$\alpha$ protons of glycine are diastereotopic in peptides and proteins, so that it is possible to excite LLS in virtually any glycine-containing peptide. We therefore considered the tripeptide Glycine-Glycine-Arginine (GGR) as a weak ligand for uPA. In the absence of protein, i.e., in the free ligand L = GGR, the lifetime $T_{LLS}$ of the two $H_\alpha$ protons in the central glycine of GGR was determined to be $T_{LLS}^f = 8.0 \pm 0.2$ s at 8 °C and 400 MHz. The ligand L = GGR was then titrated over a range 0.5 < [L] < 10 mM in the presence of 10 $\mu$M uPa at 8 °C. The results are shown in Figure 1a. For comparison, the conventional longitudinal (spin-lattice) relaxation times $T_1$ of the same $H_\alpha$ protons were also recorded as a function of the ligand concentration (Figure 1b). It is evident that under these experimental conditions, binding has virtually no effect on $T_1$ values, which can therefore not be used to study the protein-ligand interaction process. On the contrary, a full titration curve can be acquired using the lifetime $T_{LLS}$ as probe. The curve was fitted to Eq. 3, yielding the parameters reported in Table 1.

Competition experiments are based on a titration of the peptide ligand GGR in the presence of a constant amount of an additional, stronger ligand (Figure 2). This allows the simultaneous determination of the thermodynamic parameters of both the strong and weak ligands in one shot by fitting the titration curves to Eq. 4. In particular, we measured the binding affinity of 4-aminobenzamidine and UK-18. The latter is a bicylic peptide ligand with high affinity and specificity. It is important to highlight that the method presented here permits the assessment of $K_D$s in a window that spans three orders of magnitude, from 0.5 mM to 170 nM.

Materials and Methods

The synthetic tripeptide Glycine-Glycine-Arginine (GGR) (>75% purity from GenScript) was titrated over a range 0.5 < [L] < 25 mM into a solution containing 10 $\mu$M of the protein uPA prepared as explained elsewhere (Heinis C, Rutherford T, Freund S, & Winter G (2009) Phage-encoded combinatorial chemical libraries based on bicyclic peptides. Nat Chem Biol 5(7):502-507). Three different sets of data were acquired: (1) without competitor, (2) in the presence of 12 $\mu$M of 4-aminobenzamidine (98% purity from Sigma-Aldrich) and (3) in the presence of 12 $\mu$M of the synthetic cyclic peptide UK-18, produced as explained elsewhere (see Heinis et al.). An accurate amount (5 mM) of tert-butanol (99.5% Sigma-Aldrich) was added as internal concentration standard. The concentrations of the stock solutions of both protein uPA and UK-18 were measured with a NanoDrop instrument (ThermoScientific).

Experimental Procedures. During the titration, small 2 $\mu$L aliquots of a concentrated 70 mM GGR solution were added to a solution of the protein (if applicable mixed with either competing weak or strong ligands). Lifetimes $T_{LLS}$ were obtained by mono-exponential fitting of signal intensities observed with the LLS pulse sequence described in (Vasos PR, Sarkar R, & Bodenhausen G (2007) Singlet-state exchange NMR spectroscopy for the study of very slow dynamic processes. J Am Chem Soc 129(2):328-334. 28) with 10 different sustaining delays, ranging between 0.5 s < $\tau_{LLS}$ < $5T_{LLS}$. All NMR measurements were performed on a 400 MHz (9.4 T) spectrometer at 8 °C in $D_2O$.

Fitting of the Titration Curves. The experimental data were fitted to Eq.3 in the absence of a competitor. In the presence of a competing ligand, the results were fitted to

$$R_{LLS}^{W,obs} = \frac{[P]_{free}}{K_D^W + [L^W]_0} \cdot \left( R_{LLS}^{W,b} - R_{LLS}^{W,f} \right) + R_{LLS}^{W,f}$$

with

$$R_{LLS}^{W,obs}, \ R_{LLS}^{W,b}, \ R_{LLS}^{W,f}$$

the observed, bound and free LLS relaxation rates of the weak ligand, $K_D^W$ its dissociation constant and $[L^W]_0$ its total concentration. $[P]_{free}$ is the remaining free protein concentration available to bind to the weak ligand after addition of a strong ligand:

$$[P]_{free} = [P]_0 - \frac{\left([P]_0 + [L^S]_0 + K_D^S\right) - \sqrt{\left([P]_0 + [L^S]_0 + K_D^S\right)^2 - 4 \cdot [P]_0 \cdot [L^S]_0}}{2}$$

$$(5)$$

with $[L^S]_0$ the total competing strong ligand concentration, $K_D^S$ its dissociation constant.

Optimization of the Structure of the Ligand and of the Protein-Ligand Complex and Chemical Shifts Predictions. The structures of free GGR and of the GGR-uPA complex in water were optimized using Gromacs 4.5.3 (Hess B, Kutzner C, van der Spoel D, & Lindahl E (2008) GROMACS 4: Algorithms for highly efficient, load-balanced, and scalable molecular simulation. J Chem Theory Comput 4(3):435-447 29) with the GROMOS 53a6 force field (Van Gunsteren WF, Oostenbrink C, Villa A, & Mark AE (2004) A biomolecular force field based on the free enthalpy of hydration and solvation: The GROMOS force-field parameter sets 53A5 and 53A6. J Comput Chem 25(13):1656-1676.). The chemical shifts for the free and bound ligands were then calculated using these structures as input for Camshift 1.35 (Vendruscolo M, Kohlhoff KJ, Robustelli P, Cavalli A, & Salvatella X (2009) Fast and Accurate Predictions of Protein NMR Chemical Shifts from Interatomic Distances. J Am Chem Soc 131(39):13894).

**Claims**

1. Method for the determination of the binding properties of at least one first chemical compound to at least one second chemical compound between a free essentially dissociated state and a bound essentially associated state by using nuclear magnetic resonance (NMR) measurements,
   wherein at least one of the first chemical compound or the second chemical compound comprises two coupled 1/2 spins in inequivalent molecular sites wherein the relaxation of a long-lived state of the spin pair is measured as a function of the concentration of at least one of said first chemical compound or second chemical compound for the determination of the dissociation equilibrium constant ($K_D$) between the free state and the bound state,
   and wherein the dissociation constant $K_D$ of the equilibrium between the free state and the bound state

$$K_D = \frac{[P] \cdot [L]}{[PL]} = \frac{k_{off}}{k_{on}} \qquad (1)$$

   is determined based on the time constant $R_A^{obs}$ of the relaxation of the long-lived state of the spin pairs and on the following relationship

$$R_A^{obs} = \frac{[P]_0}{[L]_0 + K_D} \cdot \left( R_A^b - R_A^f \right) + R_A^f \qquad (4),$$

   where A = LLS, 1 or 2, $R_A^b$ and $R_A^f$ are the rates for the bound and free ligand, and where $[P]_0$ and $[L]_0$ are the total protein and ligand concentration.

2. Method according to any of the preceding claims, wherein the chemical shift of at least one of said spins in the free state is different from the chemical shift in the bound state,

3. Method according to any of the preceding claims, wherein the chemical shift difference between the free state and the bound state of at least one of said spins is at least 0.2 ppm, preferably at least 0.3 ppm, more preferably in the range of 0.3-4 ppm.

4. Method according to any of the preceding claims, wherein the chemical shift value of both coupled 1/2 spins in the free state is different from the respective chemical shift value in the bound state.

5. Method according to any of the preceding claims, wherein the measurement of the relaxation of a long-lived state of the spin pairs includes the steps of

   (i) generation of zero quantum coherence and longitudinal two spin order in the ensemble of spin pairs,
   (ii) evolution of the zero quantum coherence and longitudinal two spin order under suppression of the chemical shift difference, and
   (iii) conversion of the zero quantum coherence and longitudinal two spin order into a measurable coherence, and

   wherein the relaxation behaviour is determined as the time constant $R_A^{obs}$ of the decay in step (ii).

6. Method according to claim 5, wherein suppression of the chemical shift difference takes place via radiofrequency irradiation, preferably using a multi-pulse sequence or unmodulated radiofrequency continuous wave irradiation, wherein most preferably this irradiation is applied at a frequency which is centered between the two chemical shift values of the two spins in either the bound state or the free dissociated state.

7. Method according to any of the preceding claims, wherein the two coupled 1/2 spins are two protons, preferably attached to the same heteroatom, such as for example the two $H_\alpha$ protons of a glycine residue.

8. Method according to claim 7, wherein the first chemical compound is a biopolymer, preferably a protein, carbohydrate or nucleic acid-based system, or a combination thereof, and wherein the second chemical compound is a smaller, preferably monomeric or oligomeric molecular entity, preferably a potential drug compound, and wherein the two coupled 1/2 spins are spins of the smaller molecular entity, for example attached to the same heteroatom.

9. Method according to any of the preceding claims, wherein the long-lived state of the spin pair is determined under evolution conditions where interconversion to the triplet state is prevented essentially only if the corresponding chemical compound is in the free state or is in the bound state but not in the respective other state.

10. Method according to any of the preceding claims, wherein the measurement involves pulsed nuclear magnetic resonance and Fourier transform techniques, and wherein the actual measurement is carried out in a one-dimensional, or multidimensional, preferably a two-dimensional or three-dimensional manner, preferably involving transfer of magnetization between different nuclear species.

11. Use of the measurement of long-lived states in NMR for the determination of the affinity of drugs for a target biopolymer, preferably a protein, carbohydrate or nucleic acid-based system, or a combination thereof, using a method according to any of the preceding claims.

**Patentansprüche**

1. Verfahren zur Bestimmung der Bindungseigenschaften von mindestens einer ersten chemischen Verbindung an mindestens eine zweite chemische Verbindung zwischen einem freien, im Wesentlichen dissoziierten Zustand und einem gebundenen, im Wesentlichen angegliederten Zustand, unter Verwendung von Kernmagnetresonanz-(NMR-) Messungen,
wobei mindestens eine der ersten chemischen Verbindung oder der zweiten chemischen Verbindung zwei gekoppelte 1/2 Spins an nicht-equivalenten molekularen Stellen aufweist, wobei die Relaxation eines langlebigen Zustands des Spin-Paars gemessen wird als eine Funktion der Konzentration der mindestens einen der besagten ersten chemischen Verbindung oder zweiten chemischen Verbindung zur Bestimmung der Dissoziations-Gleichgewichtskonstante ($K_D$) zwischen dem freien Zustand und dem gebundenen Zustand,
und wobei die Dissoziationskonstante $K_D$ des Gleichgewichts zwischen dem freien Zustand und dem gebundenen Zustand

$$K_D = \frac{[P] \cdot [L]}{[PL]} = \frac{k_{off}}{k_{on}} \qquad (1)$$

bestimmt wird basierend auf der Zeitkonstante $R_A^{obs}$ der Relaxation des langlebigen Zustands der Spin-Paare und auf der folgenden Beziehung

$$R_A^{obs} = \frac{[P]_0}{[L]_0 + K_D} \cdot \left( R_A^b - R_A^f \right) + R_A^f \qquad (4),$$

wobei A=LLS, 1 oder 2, $R_A^b$ und $R_A^f$ Masse für den gebundenen und freien Liganden sind, und wobei $[P]_0$ und $[L]_0$ die totale Protein- und Liganden-Konzentration sind.

2. Verfahren gemäss einem der vorhergehenden Ansprüche, wobei die chemische Verschiebung mindestens einem der besagten Spins im freien Zustand sich unterscheidet von der chemischen Verschiebung im gebundenen Zustand.

3. Verfahren gemäss einem der vorhergehenden Ansprüche, wobei die Differenz der chemischen Verschiebung zwischen dem freien Zustand und dem gebundenen Zustand mindestens eines der besagten Spins mindestens 0.2 ppm beträgt, vorzugsweise mindestens 0.3 ppm, insbesondere bevorzugt im Bereich von 0.3-4 ppm.

4. Verfahren gemäss einem der vorhergehenden Ansprüche, wobei der chemische Verschiebungswert der beiden gekoppelten 1/2 Spins im freien Zustand sich unterscheidet vom entsprechenden chemischen Verschiebungswert im gebundenen Zustand.

5. Verfahren gemäss einem der vorhergehenden Ansprüche, wobei die Messung der Relaxation eines langlebigen Zustands des Spin-Paars die folgenden Schritte beinhaltet:

   (i) Erzeugung von Null-Quanten-Kohärenz und von longitudinaler Zwei-Spin-Ordnung im Ensemble von Spin-Paaren,
   (ii) Evolution der Null-Quanten-Kohärenz und der longitudinalen Zwei-Spin-Ordnung unter Suppression der Differenz der chemischen Verschiebung, und
   (iii) Umwandlung der Null-Quanten-Kohärenz und der longitudinalen Zwei-Spin-Ordnung in eine messbare Kohärenz, und

   wobei das Relaxationsverhalten bestimmt wird als die Zeitkonstante $R_A^{obs}$ des Zerfalls in Schritt (ii).

6. Verfahren gemäss Anspruch 5, wobei die Unterdrückung der Differenz der chemischen Verschiebung mittels Radiofrequenz-Bestrahlung stattfindet, vorzugsweise unter Verwendung einer Multi-Puls-Sequenz- oder unmodulierter Radiofrequenz-Dauerstrich-Bestrahlung, wobei am meisten bevorzugt diese Bestrahlung in einer Frequenz angewandt wird, welche zwischen den beiden chemischen Verschiebungswerten der beiden Spins in entweder dem gebundenen Zustand oder dem freien, dissoziierten Zustand gemittelt ist.

7. Verfahren gemäss einem der vorhergehenden Ansprüche, wobei die beiden gekoppelten 1/2 Spins zwei Protonen sind, vorzugsweise am gleichen Heteroatom befestigt, wie beispielsweise die beiden $H_\alpha$ Protonen eines Glyzin-Rests.

8. Verfahren gemäss Anspruch 7, wobei die erste chemische Verbindung ein Biopolymer ist, vorzugsweise ein Protein, Kohlenhydrat oder Nukleinsäure-basiertes System, oder eine Kombination davon, und wobei die zweite chemische Verbindung eine kleinere, vorzugsweise monomere oder oligomere molekulare Einheit ist, vorzugsweise eine potentielle Medikamenten-Verbindung, und wobei die zwei gekoppelten 1/2 Spins Spins der kleineren molekularen Einheit sind, beispielsweise am selben Heteroatom befestigt.

9. Verfahren gemäss einem der vorhergehenden Ansprüche, wobei der langlebige Zustand des Spin-Paars unter Evolutionsbedingungen bestimmt wird, in denen Interkonversion zum Triplet-Zustand im Wesentlichen nur verhindert wird, wenn die entsprechende chemische Verbindung im freien Zustand ist oder im gebundenen Zustand ist, aber nicht im entsprechenden anderen Zustand ist.

10. Verfahren gemäss einem der vorhergehenden Ansprüche, wobei die Messung gepulste Kernmagnetresonanz- und Fourier-Transform-Techniken einschliesst, und wobei die eigentliche Messung in einer eindimensionalen, oder multidimensionalen, vorzugsweise einer zweidimensionalen oder dreidimensionalen Art durchgeführt wird, vorzugsweise unter Verwendung eines Transfers von Magnetisierung zwischen unterschiedlichen Kernspezies.

11. Verwendung der Messung von langlebigen Zuständen in NMR zur Bestimmung der Affinität von Medikamenten für ein Ziel-Biopolymer, vorzugsweise ein Protein, Kohlenhydrat oder Nukleinsäure-basiertes System, oder eine Kombination davon, unter Verwendung eines Verfahrens gemäss einem der vorhergehenden Ansprüche.

**Revendications**

1. Méthode pour la détermination des propriétés de liaison d'au moins une premier composé chimique à au moins un deuxième composé chimique entre un état libre essentiellement dissocié et un état lié essentiellement associé en utilisant des mesures de résonance magnétique nucléaire (RMN),

dans laquelle au moins un du premier composé chimique ou du deuxième composé chimique comprend deux spins 1/2 couplés dans des sites moléculaire non équivalents dans laquelle la relaxation d'un état à longue vie de la paire de spins est mesuré en fonction de la concentration d'au moins un duditpremier composé chimique ou deuxième composé chimique pour la détermination de la constante de dissociation ($K_D$) entre l'état libre et l'état lié, et dans laquelle la constante de dissociation ($K_D$) de l'équilibre entre l'état libre et l'état lié

$$K_D = \frac{[P] \cdot [L]}{[PL]} = \frac{k_{off}}{k_{on}} \tag{1}$$

est déterminée sur la base de la constante temps $R_A^{obs}$ de relaxation de l'état à longue vie de la paire de spins et de la relation suivante

$$R_A^{obs} = \frac{[P]_0}{[L]_0 + K_D} \cdot \left( R_A^b - R_A^f \right) + R_A^f \tag{4}$$

où A = LLS, 1 ou 2, $R_A^b$ et $R_A^f$ sont les taux pour le ligand lié et libre, et où $[P]_0$ et $[P]_L$ sont la concentration totale de protéine et ligand.

2. Méthode selon l'une quelconque des revendications précédentes, dans laquelle le déplacement chimique d'au moins un desdits spins dans l'état libre est différent du déplacement chimique dans l'état lié.

3. Méthode selon l'une quelconque des revendications précédentes, dans laquelle la différence en déplacement chimique entre l'état libre et l'état lié d'au moins un desdits spins est de au moins 0.2 ppm, préférablement de au moins 0.3 ppm, plus préférablement de au moins 0.3 à 4 ppm.

4. Méthode selon l'une quelconque des revendications précédentes, dans laquelle la valeur du déplacement chimique des deux spins 1/2 couplés dans l'état libre est différente à la valeur du déplacement chimique respectif dans l'état lié.

5. Méthode selon l'une quelconque des revendications précédentes, dans laquelle la mesure de la relaxation d'un état à longue vie de la paire de spins inclut les étapes de

   (i) génération d'une cohérence quantique nulle et d'ordre à deux spins longitudinal dans l'ensemble des paires de spins,
   (ii) évolution de la cohérence quantique nulle et de l'ordre à deux spins longitudinal sous suppression de la différence en déplacement chimique,
   (iii) conversion de la cohérence quantique nulle et de l'ordre à deux spins longitudinal en une cohérence mesurable, et

   dans laquelle le comportement de relaxation est déterminé comme la constante temps $R_A^{obs}$ de la décroissance dans l'étape (ii).

6. Méthode selon la revendication 5, dans laquelle la suppression de la différence en déplacement chimique prend place par irradiation par radiofréquence, préférablement en utilisant une séquence à multipulsation ou une irradiation par radiofréquence non modulée à onde continue, dans laquelle le plus préférablement cette irradiation est appliquée à une fréquence qui est centrée entre les deux valeurs de déplacement chimique des deux spins dans l'état lié ou l'état libre.

**7.** Méthode selon l'une quelconque des revendications précédentes, dans laquelle les deux spins 1/2 couplés sont deux protons, préférablement attachés au même hétéroatome, tel que par exemple deux protons H$_\alpha$ d'un résidu glycine.

**8.** Méthode selon la revendications 7, dans laquelle le premier composé chimique est un biopolymère, préférablement une protéine, carbohydrate ou système à base d'acide nucléique, ou une combinaison de ceux-ci, et dans laquelle le deuxième composé chimique est une entité de taille inférieure, préférablement une entité monomère ou oligomère moléculaire, préférablement un potentiel composé médicamenteux, et dans laquelle les deux spins 1/2 couplés sont les spins de l'entité moléculaire à taille inférieure, par exemple attachés au même hétéroatome.

**9.** Méthode selon l'une quelconque des revendications précédentes, dans laquelle l'état à longue vie de la paire de spins est déterminé sous des conditions d'évolution où l'interconversion vers l'état triplet est essentiellement empêché seulement si le composé chimique correspondant est dans l'état libre ou dans l'état lié mais pas dans l'autre état respectif.

**10.** Méthode selon l'une quelconque des revendications précédentes, dans laquelle la mesure implique la résonance magnétique nucléaire pulsée et les techniques de transformation Fourier, et dans laquelle la mesure actuelle est effectuée de manière unidimensionnelle, ou multidimensionnelle, préférablement bidimensionnelle ou tridimensionnelle, préférablement impliquant un transfert de magnétisation entre différentes espèces nucléaires.

**11.** Utilisation de la mesure d'états à longue vie dans RMN pour la détermination de l'affinité de médicaments pour un biopolymère ciblé,préférablement une protéine, carbohydrate ou système à base d'acide nucléique, ou une combinaison de ceux-ci, en utilisant une méthode selon l'une quelconque des revendications précédentes.

FIG. 1

FIG. 2

FIG. 3

## REFERENCES CITED IN THE DESCRIPTION

### Non-patent literature cited in the description

- **VALENSIN.** Selective H-NMR relaxation investigations of membrane-bound drugs in vitro. *Biophysical Chemistry,* 1985, vol. 22, 83-87
- **CARRAVETTA M ; LEVITT MH.** Long-lived nuclear spin states in high-field solution NMR. *J Am Chem Soc,* 2004, vol. 126 (20), 6228-6229
- **HEINIS C ; RUTHERFORD T ; FREUND S ; WINTER G.** Phage-encoded combinatorial chemical libraries based on bicyclic peptides. *Nat Chem Biol,* 2009, vol. 5 (7), 502-507
- **VASOS PR ; SARKAR R ; BODENHAUSEN G.** Singlet-state exchange NMR spectroscopy for the study of very slow dynamic processes. *J Am Chem Soc,* 2007, vol. 129 (2), 328-334
- **HESS B ; KUTZNER C ; VAN DER SPOEL D ; LINDAHL E.** GROMACS 4: Algorithms for highly efficient, load-balanced, and scalable molecular simulation. *J Chem Theory Comput,* 2008, vol. 4 (3), 435-447 29
- **VAN GUNSTEREN WF ; OOSTENBRINK C ; VILLA A ; MARK AE.** A biomolecular force field based on the free enthalpy of hydration and solvation: The GROMOS force-field parameter sets 53A5 and 53A6. *J Comput Chem,* 2004, vol. 25 (13), 1656-1676
- **VENDRUSCOLO M ; KOHLHOFF KJ ; ROBUSTELLI P ; CAVALLI A ; SALVATELLA X.** Fast and Accurate Predictions of Protein NMR Chemical Shifts from Interatomic Distances. *J Am Chem Soc,* 2009, vol. 131 (39), 13894